# EUROPEAN PATENT SPECIFICATION

(11) **EP 0 486 444 B1**
(45) Date of publication and mention of the grant of the patent: **21.08.1996**
(21) Application number: 91830496.5
(22) Date of filing: 13.11.1991
(51) Int. Cl.: H01L 27/115, G11C 16/06, H01L 23/522

(54) **Double metal, bank erasable, flash-EPROM memory**
Aggregatslöschbare Flash-EPROM-Anordnung mit zwei Metallschichten
Mémoire flash-EPROM à double métallisation et effaçable par groupes

(30) Priority: 16.11.1990 IT 8364990
(43) Date of publication of application: 20.05.1992
(73) Proprietor: SGS-THOMSON MICROELECTRONICS S.r.l., I-20041 Agrate Brianza (Milano) (IT)
(72) Inventor: Natale, Virginia, I-20123 Milano (IT); Petrosino, Gianluca, I-22067 Missaglia (IT); Scarra', Flavio, I-20041 Agrate Brianza (IT)
(74) Representative: Pellegri, Alberto

(56) References cited:
- EP-A- 0 436 475
- FR-A- 2 572 836

## Description

### FIELD OF THE INVENTION

The present invention relates to a FLASH-EPROM, or more briefly to a FLASH memory having a double-metal architecture, whereby selectable sectors of the memory may be separately erased.

### BACKGROUND OF THE INVENTION

FLASH memories are rapidly finding numerous new fields of application. Their success is primarily due to the relatively small dimension of the unit cell, which is about equal to that of a traditional EPROM cell, coupled to the ability of being electrically erased. These characteristics ideally place FLASH memories between traditional EPROM memories (less expensive) and the EEPROM memories (much more expensive) from which they differ on one hand by being electrically erasable although the erasing can be carried out exclusively on the memory matrix as a whole, while an EEPROM memory may be erased byte by byte. On the other hand, a typical EEPROM unit cell is about four times larger than a FLASH cell.

This explains why the FLASH memories have conquered large sectors of the market where it is important to have nonvolatile, large-capacity memories which may be electrically erased eventually, but whose cost is relatively moderate.

An EPROM device is described in EP-A-0 436 475 which is cited pursuant to Art. 54(3)EPC.

One of the industrial sectors which is particularly interested to this type of memories is the automotive sector where on-board reprogramming of the memories is an indispensable requirement, e.g. for modifying the controlling parameters of a motor from time to time, or for recording the operating hystory of a motor between services, and the like.

In this as in other areas of utilization of FLASH memories, it would be highly desirable to be able to erase not the memory as a whole, but only a selectable portion of sector thereof. Such a possibility would be extremely useful. In the automotive area for example, manufacturers would find useful to install a FLASH memory wherein a system's managing program (ABS, control parameters of the motor, etc.) could be permanently stored, while on the other hand being able to modify the data stored by the program itself (e.g. timing and carburation parameters, temperature, etc., which have been acquired during the use of the vehicle and which must be erased after having been read by the computer of the maintenance workshop).

### OBJECTIVE AND SUMMARY OF THE INVENTION

An object of the present invention is that of providing a FLASH-memory wherein the erasing may take place in a partialized manner on selectable portions of the memory matrix without affecting other portions thereof.

This objective is fully met by the FLASH memory object of the present invention, having an architecture characterized by the presence of source lines which are patterned in a second level metal layer (metal 2) which lines are individually selectable by an appropriate selection circuitry of the memory and which, through interconnection vias between the second and the first level metal and through contacts between the first level metal and the semiconductor, the line of source regions of the memory cells arranged on a same row of the matrix are connected. The interruption of the lines of source regions and the separate connection of these partitioned source lines by means of "secondary" source lines patterned in metal 2 which may be brought out of the FLASH matrix orthogonally in respect to the bitlines, permits the selection of portions of the memory matrix to be erased by a dedicated external selection circuitry and to apply the erasing voltage through the selected secondary source lines, which during the reading are customarily connected to a common ground node.

### BRIEF DESCRIPTION OF THE DRAWINGS

The various aspects and advantages of the invention will become more evident through the following description of a preferred embodiment and the reference to the appended drawings, wherein:
**Figure 1** schematically shows the typical circuit arrangement of a FLASH memory cell matrix;
**Figure 2** is a partial schematic plan view showing the architecture of a cell matrix of a FLASH memory which is erasable per banks of groups of cells, in accordance with the present invention;
**Figure 3** is a partial schematic sectional view along the section line A-A of Fig. 2;
**Figure 4** is a partial schematic sectional view along the section line B-B of Fig. 2; and
**Figure 5** is a partial schematic sectional view along the section line C-C of Fig. 2.

### DESCRIPTION OF THE PREFERRED EMBODIMENT

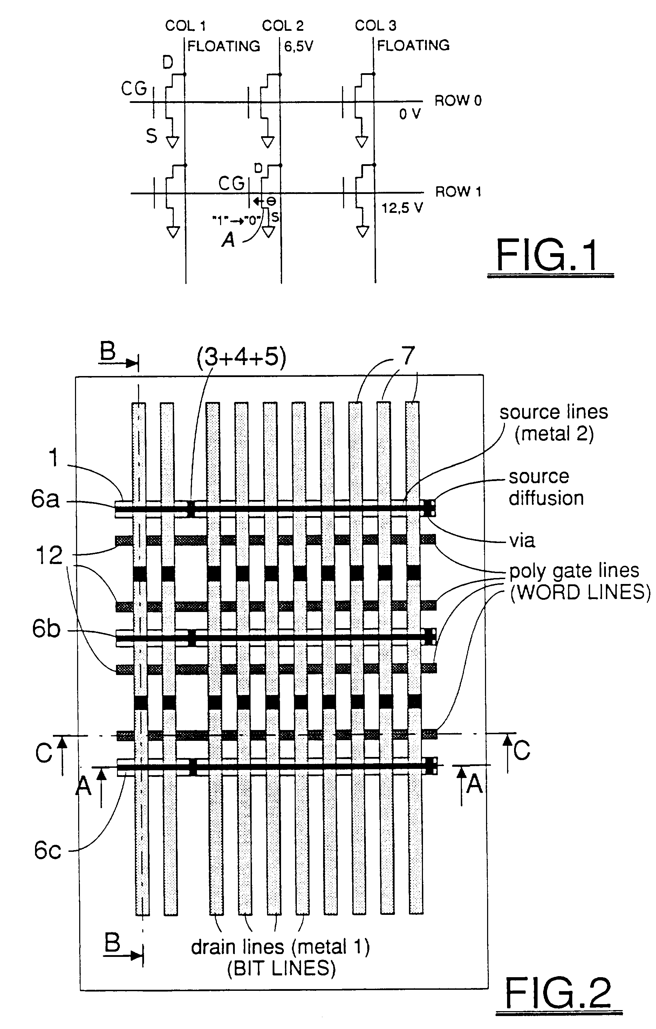

The organization in a matrix or rows and columns of the cells of a **FLASH-EPROM** memory is schematically depicted in **Fig. 1.** For illustrative purposes, the biasing conditions during a programming phase for the cell **A** are indicated in **Fig. 1.** The drain, source and control gate terminals of each unit memory cell are indicated with the letters **D**, **S** and **CG**, respectively. As may be easily observed, programming, reading and eventually erasing of the memory cells takes place by applying appropriate voltages across the three terminal structure of the single memory cells through gate lines **(WORD LINES)** relative to rows of cells; namely: row **0**, row **1**,..., drain lines **(BIT LINES)**, relative to columns of cells; namely: **col 1, col 2, col 3,**..., of the array depicted in **Fig. 1**. The source regions of the single memory cells are substantially connected in common, normally to a common ground potential during the reading of the data stored in the memory. In particular the erasing of a cell takes place, notably, by applying a sufficient potential difference between the source to which a voltage of about **12 V** is commonly applied, and the gate which may be connected to ground potential, while the drain region is left floating.

As schematically depicted in the partial plan view of **Fig. 2,** the architecture of the FLASH-memory matrix of the invention contemplates the interruption of the normally continuous and interconnected diffused regions commonly known as "source lines" constituting common source regions for all the cells arranged on a same row of the matrix and their separate connection to a series of conducting metal lines, or secondary source lines through one or more contacts formed between each portion of the diffused source regions and patterned portions of a first level metal layer (metal **1**) through a first isolation dielectric layer **14**, and through as many interconnection vias formed between said patterned portions of the metal **1** and patterned portions of a second level metal (metal **2**), which is purposely formed at least over the area occupied by the memory cell matrix in the integrated device, through a second isolation dielectric layer **15**. Said secondary source lines, patterned in metal **2**, are brought out of the FLASH matrix orthogonally to the bit lines **(DRAIN LINES)** and may be connected to an external dedicated selection circuitry (not shown in the figures).

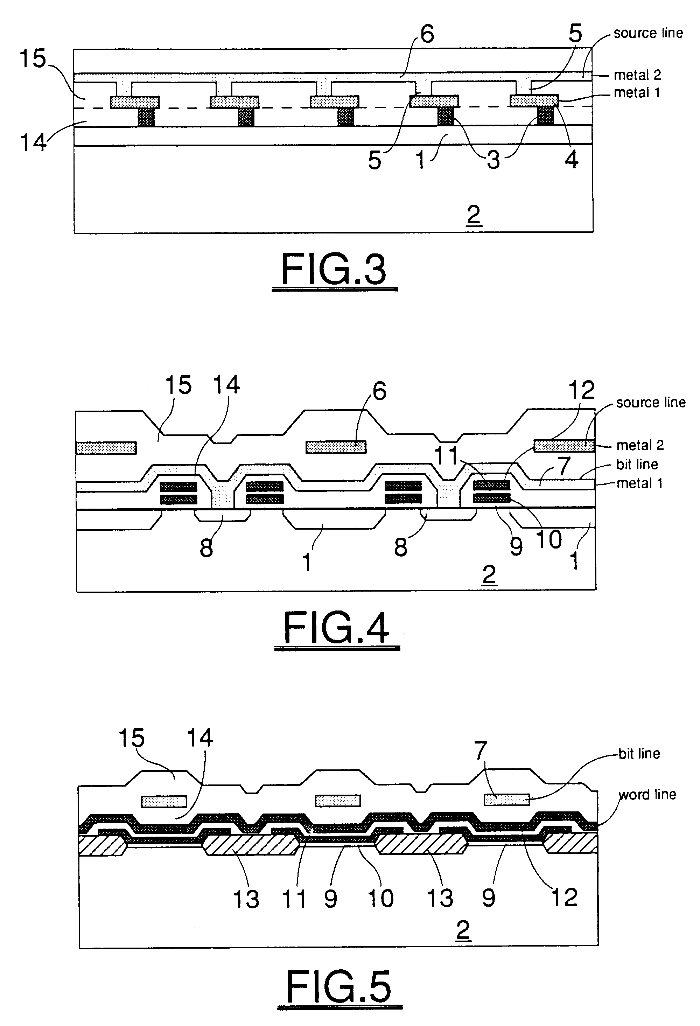

The architecture of the FLASH memory matrix of the invention is clearly depicted in the three sectional views shown in **Figures 3**, **4** and **5,** respectively.

A partial schematic sectional view along the section line **A-A** of **Fig. 2** is shown in **Fig. 3**. Each source diffusion region **1** or portion thereof formed in the semi-conducting substrate **2** and common to unit cells arranged on a same row of the matrix, is electrically connected through a plurality of contacts **3** to patterned portions **4** of a first level metal layer and through as many interconnection vias **5** to a line **6** patterned in a second level metal layer (metal **2**). For completeness of illustration, the cross sectional view along the section line **B-B** of **Fig. 2** shown in **Fig. 4** and the cross sectional view along the section line **C-C** of **Fig. 2,** shown in **Fig. 5**, clearly show the structure of the FLASH-EPROM cells which form the matrix. In particular, in the cross section of **Fig. 4,** taken along a bit line, the arrangement of the cells aligned along a same column or drain line **7** may be observed. The diffused drain regions are indicated with **8** while the gate structure of each cell is formed by the thin dielectric gate layer **9**, by a first level layer of polycrystalline silicon (poly **1**) **10**, which forms the floating gate of the device, by an intermediate dielectric insulating layer **11** and by a second level polycrystalline silicon layer (poly **2**) **12** which constitutes the control gate, i.e. the gate lines or **WORD LINES** of the device. In the sectional view, taken along a **WORD LINE** or gate line, along the section line **C-C,** orthogonal to the sectional line **B-B** of **Fig. 2**, the cross section of the cells arranged along a same row of the matrix may be observed. In this sectional view, the field isolation structure formed by the field oxide strips **13** may be also observed.

Depending upon the number of cells which are aligned along a same row of the matrix (number of bytes or words), the electrical connection between the respective source diffusion **1** (e.g. common to all the cells of a same row) and the overlying secondary source line **6**, patterned in metal **2**, may be realized through a plurality of conductive paths (i.e. contact **3**, patterned portion **4** of metal **1**, interconnection via **5**) uniformly distributed along the length of the row (e.g. every eight or sixteen bit lines), in order to reduce the electrical resistance of the connection.

The ends of the various secondary source lines **6**, brought out of the matrix orthogonally to the bit lines **7**, may be interconnected as needed into separate groups, each group of source lines may then be individually connected to a dedicated selection circuit, thus permitting the erasing of the FLASH memory matrix by selectable groups or banks of cells.

In the example of **Fig. 2**, the presence of three secondary source lines, **6a, 6b** and **6c**, respectively, which are individually connectable to an external selection circuit, permits the erasing by banks of cells. In fact the cells of the top row and eventually of other overlying rows (not visible in **Fig. 2**) may be erased by biasing them through the respective secondary source lines **6a**, ..., and/or the cells of the two central rows of the figure, may be erased by biasing them through the common secondary source line **6b**, and/or the cells of the lower row of the figure and eventually of other underlying rows of cells (not visible in the figure), may be erased, by biasing them through the respective secondary source lines **6c**, ... . Therefore, in the embodiment shown, the matrix may be erased by banks of two adjacent rows of cells for each secondary source line, through which they may be separately biased from the other rows of cells of the matrix.

Naturally, a common source diffusion for the cells of a row of the matrix may also be segmented, for example in two segments and, similarly, the relative secondary source line patterned in metal **2** may be segmented, in order to permit a further subdivision in selectable groups of the cells of the matrix.

## Claims

1. A FLASH-EPROM memory formed by a plurality of unit memory cells integrated in a semiconductor substrate (2), each cell having a drain region (8), a gate structure (10,11,12) and a source region (1), the cells being organized in a matrix of rows and columns being individually addressable through a family of individually selectable parallel conducting word lines (12) and a family of individually selectable parallel conducting bit lines (7), patterned in a first-level metal layer disposed on a first isolating dielectric layer (14), each WORD LINE being part of said gate structure of the cells aligned along a certain row and each BIT LINE being connected through contacts formed through said first isolating dielectric layer to a drain region of the cells aligned along a certain column, the memory cells being erasable as a group by application of an erasing voltage to common source regions formed in said semiconducting substrate; the memory comprising
a family of individually selectable parallel conducting SECONDARY SOURCE LINES (6) and patterned in a second-level metal layer disposed over a second insulating dielectric layer (15) lying over said bit lines ;
each SECONDARY SOURCE LINE of said family of secondary source lines being connected to a common source region (1) of the unit cells belonging to a certain row between said common source region through a contact (3) and a patterned portion (4) of said first-level metal layer and an interconnection via (5) between said patterned portion and said conducting secondary source line, thus permitting the erasing of groups of unit cells of said matrix sharing a common source region through a selected conducting SECONDARY SOURCE LINE.

2. A FLASH-EPROM according to claim 1, wherein said conducting secondary source lines run parallel above said commmon source diffused regions of unit cells belonging to respective rows of the matrix.

3. A FLASH-EPROM memory according to claim 1, wherein said family of conducting secondary source lines is brought out of the area occupied by said matrix of unit cells through a side of said area orthogonal to the side through which said family of conducting bit lines is brought out.

## Patentansprüche

1. FLASH-EPROM-Speicher, der durch mehrere Einheitsspeicherzellen gebildet ist, die auf einem Halbleitersubstrat (2) integriert sind, wobei jede Zelle einen Drain-Bereich (8), eine Gate-Struktur (10, 11, 12) und einen Source-Bereich (1) besitzt, die Zellen in einer Matrix in Zeilen und Spalten organisiert sind, die über eine Gruppe von einzeln auswählbaren parallel verlaufenden Wortleitungen (12) und eine Gruppe von einzeln auswählbaren parallel verlaufenden Bitleitungen (7), die in einer Metallschicht in einer ersten Ebene auf einer ersten dielektrischen Isolierschicht (14) ausgebildet sind, einzeln adressierbar sind, jede Wortleitung ein Teil der Gate-Struktur der längs einer bestimmten Zeile angeordneten Zellen ist und jede Bitleitung über Kontakte, die durch die erste dielektrische Isolierschicht ausgebildet sind, mit dem Drain-Bereich der Zellen, die längs einer bestimmten Spalte angeordnet sind, verbunden ist, und wobei die Speicherzellen in Gruppen gelöscht werden können, indem eine Löschspannung an die gemeinsamen Source-Bereiche, die auf dem Halbleitersubstrat ausgebildet sind, angelegt wird; wobei der Speicher umfaßt:
eine Gruppe von einzeln auswählbaren, parallel verlaufenden sekundären Source-Leitungen (6), die in einer Metallschicht in einer zweiten Ebene über einer zweiten dielektrischen Isolierschicht (15), die über den Bitleitungen liegt, ausgebildet sind; wobei
jede sekundäre Source-Leitung der Gruppe der sekundären Source-Leitungen mit einem gemeinsamen Source-Bereich (1) der Einheitszellen, die zu einer bestimmten Zeile gehören, zwischen dem gemeinsamen Source-Bereich über eine Kontaktierung (3) und einen Musterabschnitt (4) der Metallschicht in der ersten Ebene sowie eine Zwischenkontaktierung (5) zwischen dem Musterabschnitt und der leitenden sekundären Source-Leitung verbunden ist, wodurch das Löschen von Gruppen von Einheitszellen der Matrix, die einen gemeinsamen Source-Bereich über eine ausgewählte leitende sekundäre Source-Leitung teilen, möglich wird.

2. FLASH-EPROM nach Anspruch 1, bei dem die leitenden sekundären Source-Leitungen über den gemeinsamen diffundierten Source-Bereichen der Einheitszellen, die zu entsprechenden Zeilen der Matrix gehören, parallel verlaufen.

3. FLASH-EPROM-Speicher nach Anspruch 1, bei dem die Gruppe von leitenden sekundären Source-Leitungen über eine Seite des von der Matrix der Einheitszellen belegten Bereichs herausgeführt sind, die senkrecht zu der Seite liegt, über die die Gruppe der leitenden Bitleitungen herausgeführt ist.

## Revendications

1. Mémoire FLASH-EPROM constituée d'une pluralité de cellules mémoire élémentaires intégrées dans un substrat semiconducteur (2), chaque cellule ayant une région de drain (8), une structure de grille (10, 11, 12) et une région de source (1), les cellules étant organisées en une matrice de rangées et de colonnes, individuellement adressables par l'intermédiaire d'une famille de lignes de mots conductrices, parallèles et sélectionnables individuellement (12) et d'une famille de lignes de bits conductrices, parallèles et sélectionnables individuellement (7), gravées dans une couche métallique de premier niveau disposée sur une première couche de diélectrique isolant (14), chaque ligne de mots faisant partie de la structure de grille des cellules alignées le long d'une certaine rangée et chaque ligne de bits étant connectée par l'intermédiaire de contacts formés à travers la première couche de diélectrique isolant aux régions de drains des cellules alignées le long d'une colonne donnée, les cellules mémoire étant effaçables par groupes par application d'une tension d'effacement à une région de source commune formée dans le substrat semiconducteur, la mémoire comprenant :
une famille de lignes de sources secondaires, conductrices, parallèles et individuellement sélectionnables (6) et gravées dans une couche métallique de second niveau disposée sur une deuxième couche de diélectrique isolant (15) reposant sur les lignes de bits ;
chaque ligne de sources secondaire de la famille de lignes de sources secondaires étant connectée à une région de source commune (1) des cellules élémentaires appartenant à une certaine rangée entre la région de source commune par l'intermédiaire d'un contact (3) et d'une partie gravée (4) de la couche métallique de premier niveau et un via d'interconnexion (5) entre la partie gravée et la ligne de sources secondaire conductrice, permettant ainsi l'effacement des groupes de cellules élémentaires de la matrice partageant une région de source commune par l'intermédiaire d'une ligne de sources secondaire conductrice sélectionnée.

2. Mémoire FLASH-EPROM selon la revendication 1, dans laquelle les lignes de sources secondaires conductrices s'étendent parallèlement au-dessus de régions diffusées de source commune des cellules élémentaires appartenant aux rangées respectives de la matrice.

3. Mémoire FLASH-EPROM selon la revendication 1, dans laquelle la famille de lignes de sources secondaires conductrices est amenée en dehors de la zone occupée par la matrice de cellules mémoire par un côté de ladite zone orthogonal au côté par lequel la famille de lignes de bits conductrices est alimentée.
